# EUROPEAN PATENT SPECIFICATION

(11) **EP 0 428 682 B1**
(45) Date of publication and mention of the grant of the patent: **26.03.1997**
(21) Application number: 90908872.6
(22) Date of filing: 17.05.1990
(51) Int. Cl.: H01J 37/305

(54) **MAGNETIC STRUCTURE FOR ELECTRON-BEAM HEATED EVAPORATION SOURCE**
MAGNETISCHE STRUKTUR FÜR EINE MITTELS ELEKTRONENSTRAHL ERWÄRMTE VERDAMPFUNGSQUELLE
STRUCTURE MAGNETIQUE POUR SOURCE D'EVAPORATION CHAUFFEE PAR UN FAISCEAU D'ELECTRONS

(30) Priority: 22.05.1989 US 355440
(43) Date of publication of application: 29.05.1991
(73) Proprietor: HANKS, Charles W., Ventura, CA 93003-1051 (US)
(72) Inventor: HANKS, Charles W., Ventura, CA 93003-1051 (US)
(74) Representative: Sanderson, Laurence Andrew
(86) International application number: PCT/US90/02851
(87) International publication number: WO 90/14682

(56) References cited:
- DE-C- 3 316 554
- US-A- 3 268 648
- US-A- 3 303 320
- US-A- 3 389 210
- US-A- 4 064 352

## Description

### FIELD OF INVENTION

Prior equipment of this general nature has employed horizontal electromagnets located at some distance from a crucible with enlongated pole pieces extending on opposite sides of the crucible to establish a magnetic field for focusing an electron beam into the crucible. Only about one-quarter of the magnetic flux generated by this arrangement is usefully employed and the rest is lost in leakage flux around the perimeter of the magnet core.

An improvement in magnet systems for electron beam focusing is achieved by generating the focusing magnetic field as close as possible to the area of use thereof i.e., the electron beam path. This is accomplished by generating a horizontal magnetic field over the top of an electron gun and crucible by a plurality of markedly smaller individual magnets arranged vertically along the two opposite sides of the beam path as contrasted to the larger magnet and extensive pole pieces previously employed. This 90 degree shift in the position of the magnets around the crucible from the usual position places one end of each magnet at the exact closest position possible to deliver its flux lines to the magnetic field area without the use of long pole pieces or shims.

A vertical crucible is placed on a steel plate which constitutes a yoke for the vertically placed magnets connecting the lower ends of the individual magnets which rest thereon on either side of the crucible. One-half of the magnets are positioned on one side of the beam path and the other half are placed on the other side, all in vertical position.

The foregoing makes for a very efficient magnet system in that essentially one-half of the leakage flux from the magnet tops is attracted to and joins the flux lines of the opposite magnets across the crucible. Leakage flux is minimized in the area of the distance from the top to the bottom of the magnet because that is more than the distance half-way to the opposite pole across the crucible. A comparison of the conventional commercial systems with the foregoing system for the same power consumption and vapor output results in a unit 357 percent smaller in magnet volume and 353 percent smaller in general volume.

The reduction in size of the assembly is accomplished mainly by increasing the efficiency of use of the magnetic system for the electron-beam gun. The only magnetic field needed in an electron beam system is in the area where the electrons move in space from emitter to target. A fairly large percentage of this flight path is somewhat high above the top of the crucible. U.S. Patent No. 3,535,428 teaches that the magnetic pole tops may be at crucible level and still have a usable field strength in the electron path. This requires laterally wide poles to help increase the field strength enough that areas somewhat high above the crucible surface have sufficient field strength.

The use of electro- (or permanent) magnets in this system utilizes one of the unique magnetic characteristics of such magnets which does not occur in steel pole systems even though using the same type of magnetic source. In a permanent magnet, all the molecular magnetic domains throughout the bar of material are forced to align in the required direction from the time of initial cooling of the material from the liquid state and particularly through the crystal growing state of the cooling cycle. Upon removal from the mold, the magnet is demagnetized to aid in processing by cutting, grinding, etc.. Magnetism can then be restored to the original magnetic state by remagnetizing to the required coercivity.

The presence of firm magnetic material in the ends of the permanent magnets and its effect on the lines force which comes out the ends of the magnet is duplicated by the effect of the presence of windings of current-carrying wire at the ends of electromagnets which force a high percentage of flux lines to go out the ends of the core. Merely using steel poles or cores at interfaces where magnetic flux lines come out of high permeability materials into vacuum at low permeability have no such auxiliary field to add a directional effect.

The strongest part of the filed on the mid-line of the beam path is substantially directly on a horizontal line between the top ends of the permanent magnets which are located on opposite sides of the crucible. This results in the beam trajectory being correct without having high poles alongside the crucible. In addition, the crucible walls above the evaporant top may be lower because the magnetic structure, which the cooled crucible walls cover, is lower.

Not only is the vertical magnetic gradient improved by the use of pairs of small vertical magnets, but also the gradient along the beam path is more easily achieved. Figure 8 of U.S. Patent No. 3,535,428 discloses the need for fields of different intensity at different parts of the beam path. In previous electron-beam systems for evaporation using transverse fields, it has been necessary to obtain the necessary magnetic gradients by shimming the main poles. This has proved to be an arduous procedure with much machining and filing, testing and fitting. In the present invention as defined in claim 1, it is easy to move the individual magnets farther apart or closer together and then lock them in position.

Conventional electron beam heated vapor sources generate a spray of electron knocked out off the evaporant surface atoms as well as some of the primaries that are elastically scattered off the surface. These come out in widely divergent directions from the surface. However, the paths of all of them are changed by the magnetic field lines to paths that are bent and focused in the same direction as the initial beam. This directs some of them onto the back end of the source, but some go on out into the vacuum charger and end up heating chamber components, usually undesirably. The energy of the errant electrons can be as high as 10% of the initial beam power. Most manufacturers of extant electron beam evaporation sources add a copper barrier connected to the rearmost water-cooler surface to intercept such electrons.

Additional vertical magnets may be added at the rear to generate a vertically high field of high intensity without disturbing the main beam-handling field. The electrons coming toward the extreme rear of the course are bent down into the water-cooled structure at the rear of the crucible.

The use of multiple sets of magnets makes it easy to set up different degrees of magnetic intensity along the beam path. However, small pole pieces may be used to allow a more gradual change in magnetic intensity or an extension of the magnetic field into areas where it is not convenient to install another magnetic structure. In general, the magnets for this use operate best without poles pieces.

This invention relates to a new and improved horizontal magnet structure for an electron beam heated evaporation source. More particularly, it relates to an electron beam heated source for use in a high vacuum environment to make high grade thin film coatings and the like. An electron-beam gun is positioned on one side of a turret containing multiple crucibles or an array of crucibles. The substance or substances which are to be evaporated are positioned in the individual crucibles. An electron beam gun is positioned such that the evaporated substance does not damage the gun. In order to direct the path of the electrons emitted from the gun to a particular crucible, a plurality of magnets is disposed horizontally on opposite sides of a particular crucible, the substance of which is being evaporated, thereby creating a transverse magnetic field extending over the top of the gun and the substance to be evaporated. Positioning the magnets guides and focuses the electrons in a convex path upward and down into the substance in the crucible. The magnets may be either permanent magnets, electro-magnets or a combination thereof.

### DESCRIPTION OF RELATED ART

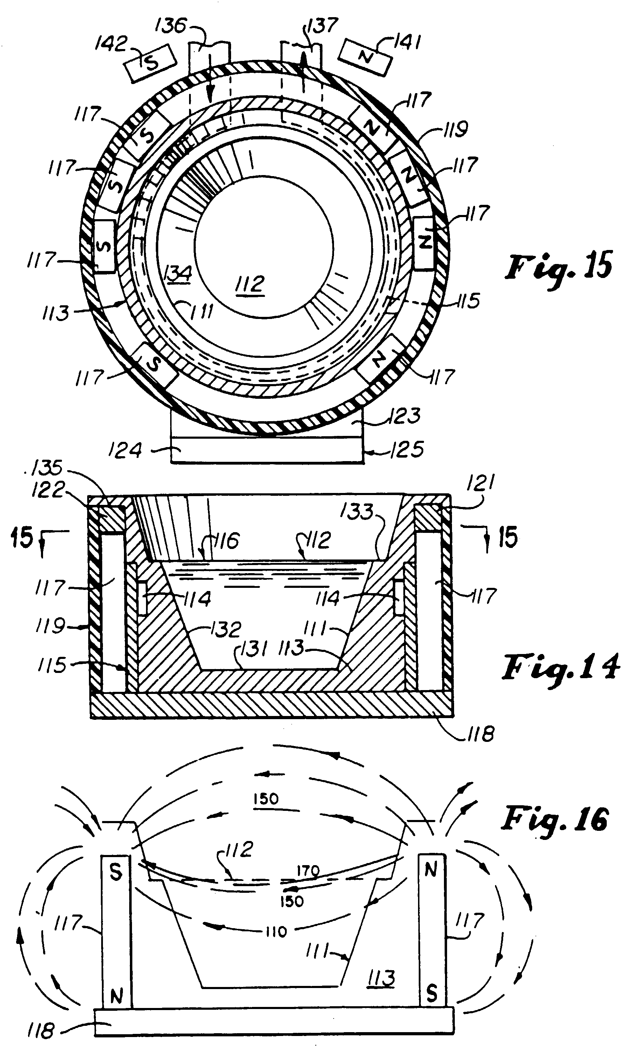

The present invention is related to and is an improvement over the invention by the same inventor of U.S. Patent No. 4,835,789, which was published on 30.5.89 and does not belong to the prior art according to Art. 54 EPC. The vertical magnet structure of this patent is illustrated in Figures 14-19 of the accompanying drawings, and referring thereto it will be seen that a hollow 111 is formed in a crucible block 113 for receiving an evaporant 112. The block 113 is preferably formed of copper and has formed on the outside thereof a water passage groove 114. A cooper sleeve 115 is placed around the outside of the crucible 113, thereby forming a closed passage 114. As best shown in Figure 15, an inlet conduit 136 and outlet conduit 137 communicate with the water passage 114 to supply water or other coolant to cool the crucible 113. The evaporant 112 is melted by an electron beam and a skull 116 forms at the side of the molten pool of evaporant 112 and prevents deleterious interchange between the material which is being evaporated and the copper crucible.

One form of the crucible as shown in Figure 14, has a bottom 131 extending horizontally near the lower edge of the block 113 and upward and outward slanted sides 132 extend to a horizontal ledge 133. The level of evaporant 112 is at or below the ledge 133. Above ledge 133, the walls of the block slant upward and outward as shown by reference numeral 134 and a horizontal shelf 135 extends around the perimeter of the hollow 111.

Individual permanent rectangular cross-section bar magnets 117 are located with their lower ends resting on a steel baseplate 118 which fits below the bottom of the crucible 113. On the exterior of the magnets 117 is an outside cover 119. Steel pole pieces 121 and 122 may be disposed on top of the magnets 117, although in the preferred embodiment of the invention these pole pieces are eliminated. Thus, on the right-hand side of Figure 15, there are provided four magnets 117 with the north poles upward and the south poles resting upon baseplate 118, whereas on the left-hand side, there are four similar magnets with their south poles uppermost. The number and position of the magnets 117 is subject to variation, the end result of their positioning being to establish a magnetic field to guide and focus the electrons in a convex path upward and then downward into the evaporant 112. An electron-beam gun 125 is shown schematically in Figure 15 as having an anode 123, and a filament-type emitter 124 positioned at, or above the level of the top of the crucible 113 and to one side thereof.

Figure 16 shows schematically the magnetic lines of force between the magnets 117 on opposite sides of crucibles 113 and marked on Figure 16 are numerals indicating field strength in gauss.

Optionally, two magnets 141 and 142 may be placed just rearward of magnets 117. Being placed closer together than the main beam-handling magnets, they generate such a high field that even full primary voltage electrons cannot get by at any normal medium-high path direction. Hence electrons coming toward the extreme rear of the source are bent down into the water-cooled structure at the rear of crucible 113.

Figures 17 and 18 illustrate the use of opposed pairs of electromagnets with each having a core 147 and coils 148 energized by a source, not shown, as an alternative to the permanent magnets described above, and Figure 19 shows a combination of D.C. electromagnets and permanent magnets.

The prior art multiple vertical magnet system for focusing an electron beam into a crucible or the like briefly described above, claims, in addition to a crucible and electron beam source, a first plurality of discrete magnets of a first polarity spaced apart from each other on one side of an electron beam path from gun to crucible and a second plurality of magnets of a second polarity spaced apart on the other side of said electron beam path with all magnets being disposed on the same side of said electron beam source. Additional claims defined the first and second plurality of magnets being of the same number, the magnets of said first and second pluralities being directly opposite each other and the magnets being permanent magnets, electromagnets and combinations thereof. Further claims define a magnetizable baseplate under the crucible with the magnets resting thereon, the magnets extending from above to below the evaporation source, pole pieces on the upper ends of the magnets and a cover extending around the outside of the magnets. A further set of claims defining this above-noted system include the limitations that all magnets are approximately equidistant from the center of the crucible, first and second polarity additional magnets disposed rearward of said first and second plurality of magnets, respectively, on opposite sides of the beam path, said additional magnets being closer together than the other magnets of opposite polarity, and the system above wherein the discrete magnets are the sole force for directing electrons in the stated path.

In the present invention plural discrete magnets are positioned horizontally rather than vertically as in the above-noted patent. References cited in the above-identified described, the prior art known to applicant. Magnetic measurements of field intensity at various positions in the crucible area as well as above and well below the crucible top show that the main source of magnetic flux along vertically placed magnets is at the top ends and the area very close to the ends. It therefore is desirable that the geometry of the emitter, magnet and multiple crucibles be constructed in accordance with the present invention whereby the magnets are horizontally disposed. Where there is a turret-like array, it would be difficult to place vertical magnets around crucibles without great magnetic complexity ensuing. By using horizontally disposed magnets, the foregoing disadvantages are overcome.

### SUMMARY OF THE INVENTION

It is possible to have the same degree of beam guidance from emitter to evaporant by placing magnets horizontally with the appropriate north and south ends placed in the same place in space as those of the vertical magnets used in a single crucible installation such as shown in U.S. Patent No. 4,835,789.

A steel base plate or magnetic return connects the captive ends of the magnets. Although this is a longer U-shaped piece than the straight, rectangular base plate shown in the aforesaid patent with vertical magnets, because steel has low magnetic reluctance, the effect of a slightly longer steel path is not discernible.

The magnetic field quality of an electron beam gun with this type of horizontal magnets appears to be better than in an electron beam gun with vertical magnets. The reason for this is because the small mount of leakage flux of the magnet from near the beam path to the other end at the junction with the steel base plate magnetic return has more effect on the main field in the crucible area than is the case of horizontal magnets where such leakage flux would be directed a further 90 degrees away from the crucible to a horizontal location well above the crucible.

A large majority of electron beam heated sources used in the United States are of a multiple crucible geometry. A group of two or more crucibles used together with means sequentially moving each individual crucible under the beam impact to generate two different vapor deposits alternatively is widely used in the optics industry to make one-quarter wave stacks and other types of thin-film bandpass filters. Furthermore, equipment which makes long evaporation runs of the same material may use multi-pocket assemblies so as to have a large stock of evaporant at hand. Commonly, multi-pocket evaporation arrays are in a disk-like turret arrangement. The turret is indexed so that each crucible in turn is brought into position where it is impacted by the electrons from the emitter. Water-cooling passageways in a central post for the turret which guides the crucible assembly rotation are sealed by elastomeric rings. Hence this type of equipment is not usable in UHV (ultra high vacuum) vacuum ranges because of outgassing of the rings. However, in UHV ranges a linear array of crucibles may be used, each crucible being pushed past the emitter position by the use of a long, sealed metal bellows arrangement to make the crucibles movable but with an all-metal construction so that there is no outgassing.

A further feature of the invention is the use of a unitary array of plural magnets having a common base.

Other objects of the present invention will become apparent upon reading the following specification and referring to the accompanying drawings in which similar characters of reference represent corresponding parts in each of the several views.

### DESCRIPTION OF THE DRAWINGS

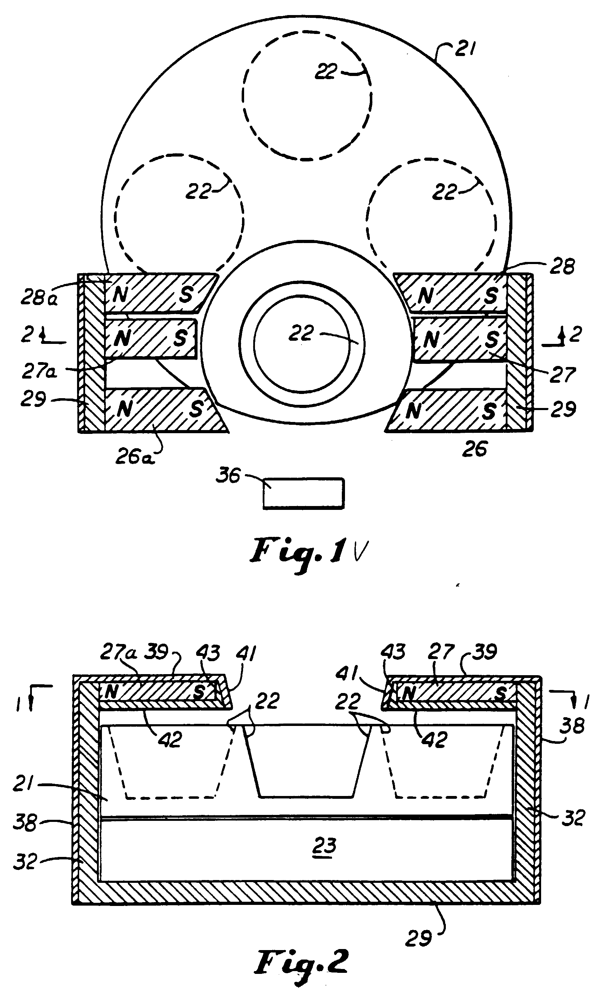

Figure 1 is a schematic top plan view of one form of the invention.

Figure 2 is a transverse vertical sectional view taken substantially in the plane 2--2 of Figure 1.

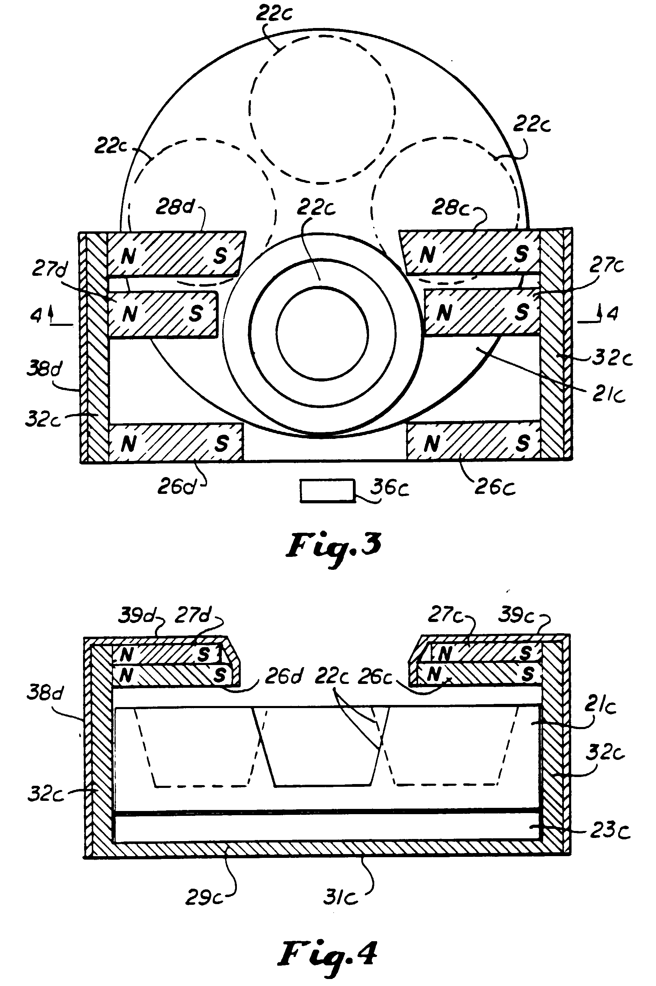

Figure 3 is a schematic top plan view of a modification.

Figure 4 is a vertical sectional view taken substantially in the plane 4--4 of Figure 3.

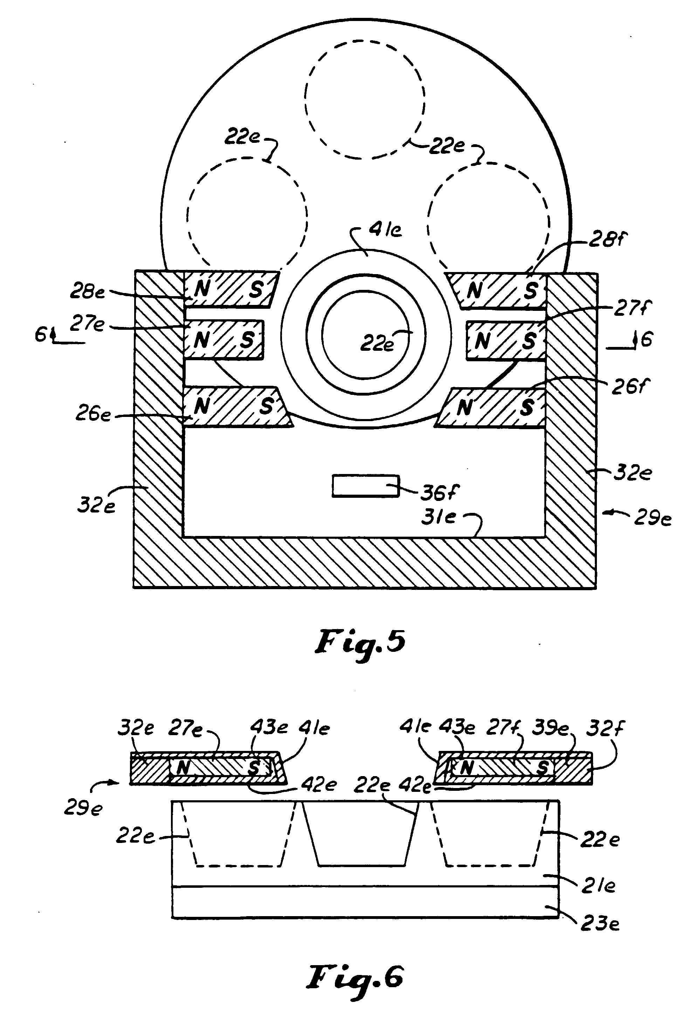

Figure 5 is a schematic top plan view of still another modification.

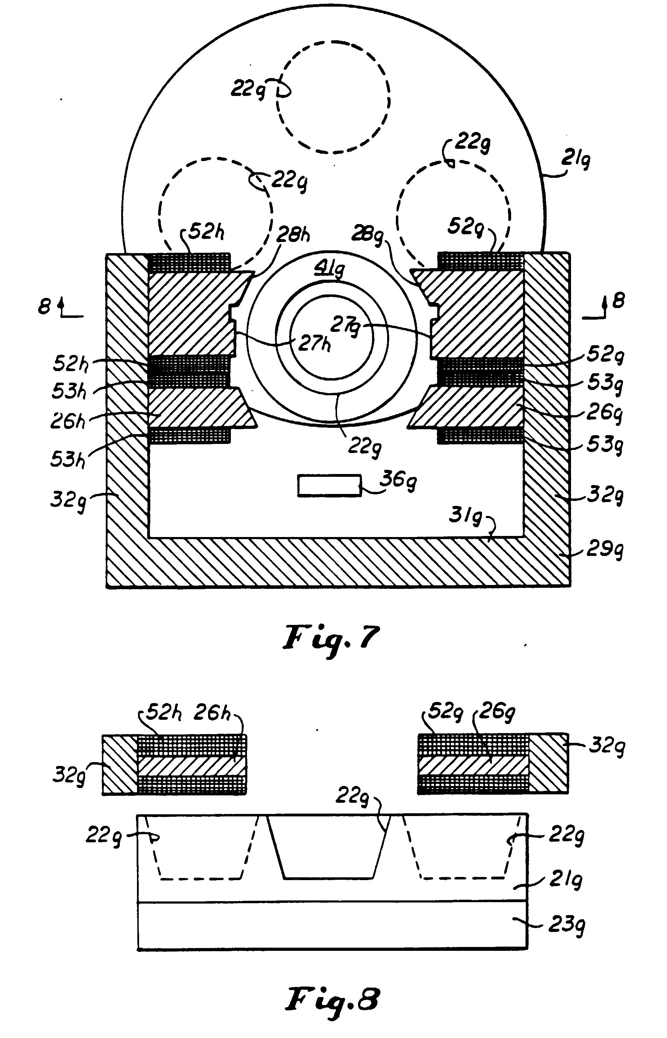

Figure 6 is a sectional view taken substantially in the plane 6--6 of Figure 5.

Figure 7 and 8 are views similar of Figures 1 and 2, respectively, modified by using electro-magnets.

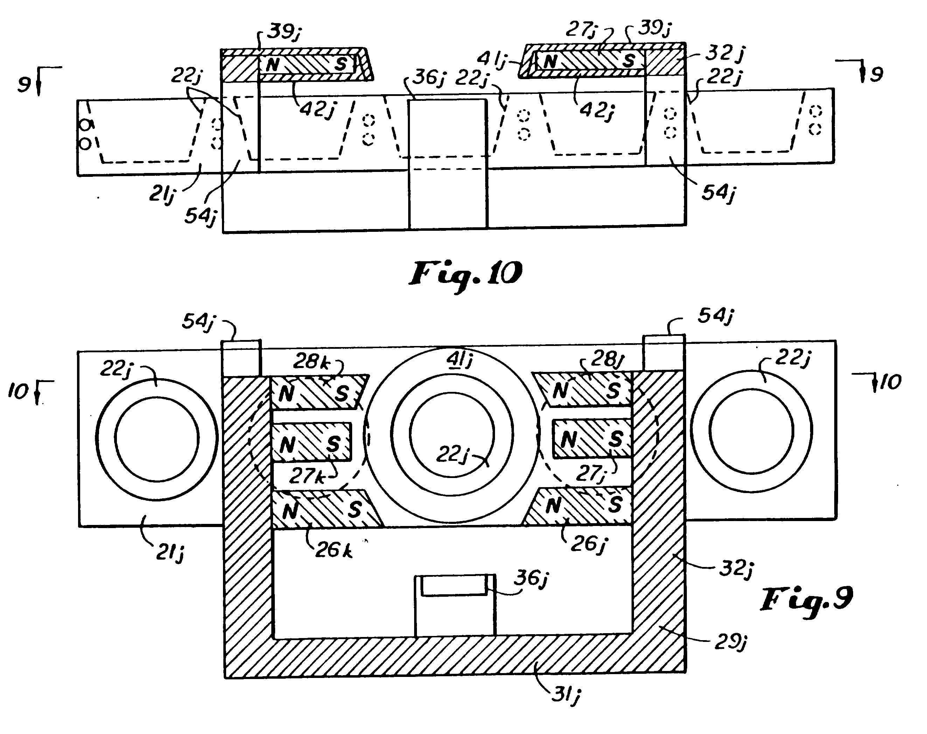

Figure 9 is a top plan view partially in section showing the invention adapted to a linear array of crucibles.

Figure 10 is a sectional view taken substantially in the plane 10--10 of Figure 9.

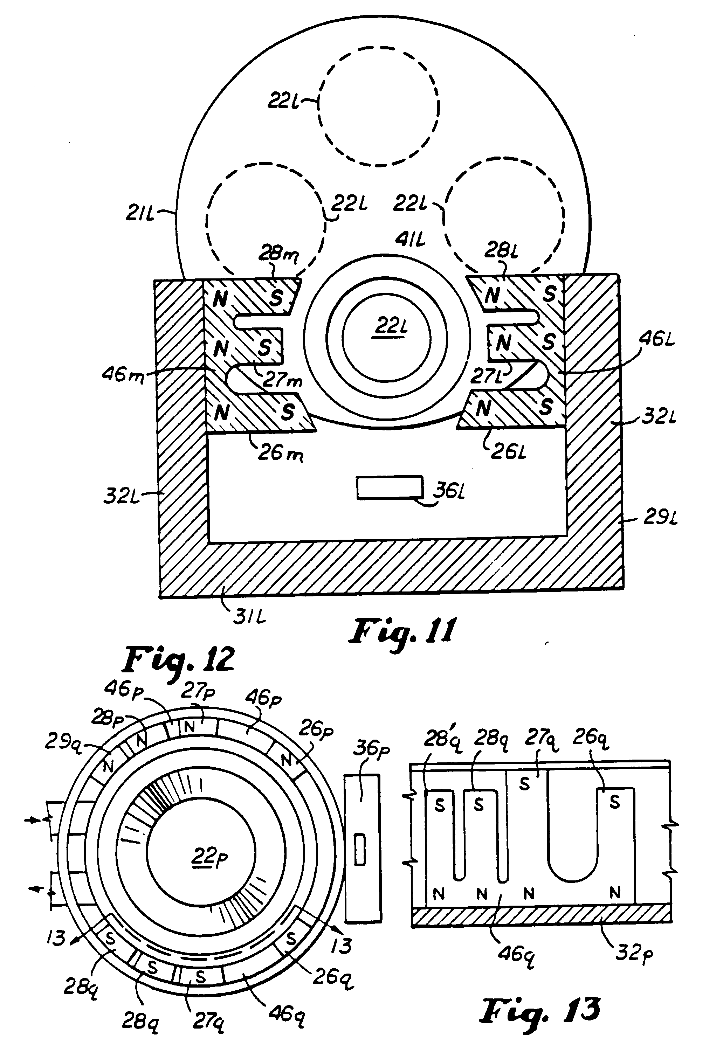

Figure 11 is a view similar to Figure 1 showing a unitary array of plural magnets having a common base.

Figure 12 is a plan view of a further embodiment having vertical arrays of magnets.

Figure 13 is a sectional view taken in the plane 13--13 of Figure 12.

Figure 14 is a central vertical sectional view of a crucible and vertical magnet system.

Figure 15 is a sectional view taken in the plane 15-15 of Figure 4.

Figure 16 is a schematic representation showing magnetic lines of force of the structure of Figure 14.

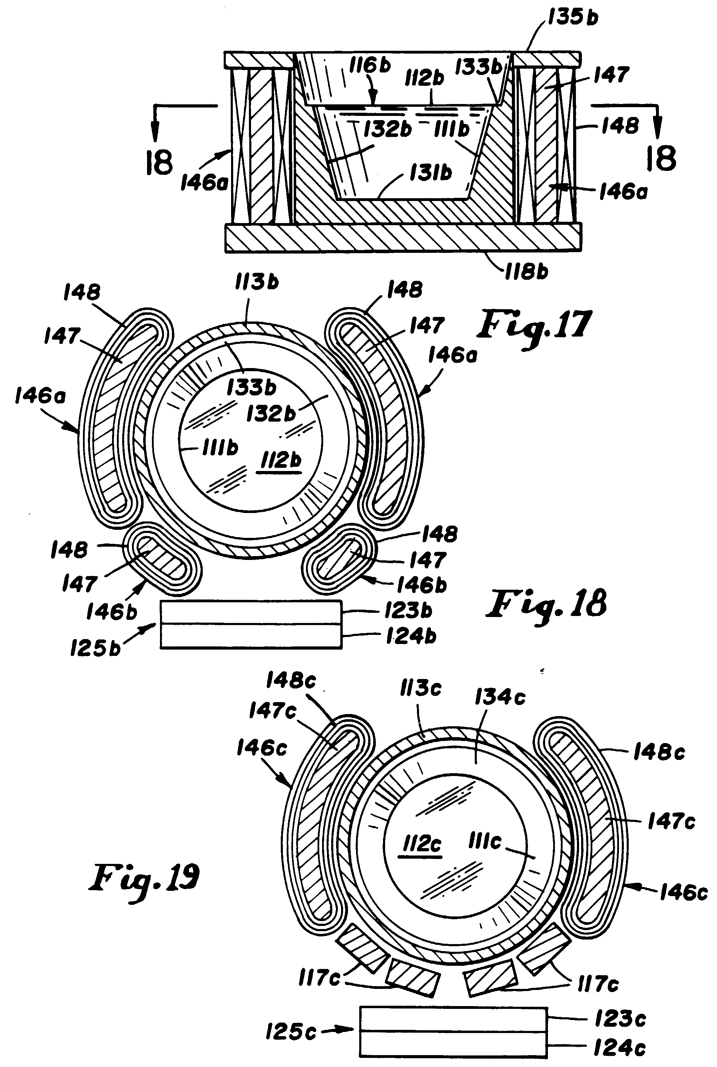

Figures 17 and 18 are views corresponding to Figures 14 and 15 and showing a modification thereof.

Figure 19 is a view similiar to Figure 18 and showing a further modification of the system thereof.

### DESCRIPTION OF PREFERRED EMBODIMENTS

Directing attention first to the modification shown in Figures 1 and 2, turret body 21 (preferably made of copper and having cooling passageways not, shown but adequately described in the aforesaid Patent No. 4,835,789) contains plural crucibles 22, here shown as four in number. It will be understood that fewer or more crucibles may be used in each turret. The evaporant in each crucible may be different. In such case, multi-layer coatings may be evaporated onto the object to be coated by rotating the turret so that one crucible at a time is brought under an electron beam source. On the other hand, the evaporant in all of the crucibles may be the same so that when the content of one crucible is exhausted, the next crucible may be brought into position in the electron path.

Various means for rotating the turret 21 may be employed, as is well understood in the art. Thus, a turret base 23 is shown and the means whereby base 23 causes turret 21 to rotate 90 degrees while maintaining the passage of coolant through the passages of the turret body is not illustrated but is well understood in this art.

Positioned above the level of the top of turret body 21 on one side of the path of electron emitted from an electron beam gun 36 are three permanent magnets, 26, 27, and 28. The magnets 26 - 28 are horizontally disposed and all on the right side of Figure 1 have their north pole positioned closest to the crucible 22 which is at any particular time being evaporated. The terms "right" and "left" are with reference to the direction of electron flight. On the other side of crucible 22 are three other magnets, 26a, 27a, 28a, all also horizontally disposed and having their south poles nearest the crucible 22. Thus, the magnets 26 - 28 on the right side directly oppose the magnets 26a - 28a on the left side, and a magnetic path is established between the magnets on one side and the other. It will be understood, of course, that instead of three magnets, any number of horizontally disposed magnets may be employed.

Steel yoke 29 is of a U-shape and has a bottom 31 below the turret base 23 and sides 32 extending up on each side of the turret base 33 and turret body 21 to the level of the magnets. The outer edge of each magnet 26 - 28 and 26a - 28a is in direct contact with one of the side 32 of yoke 29.

For efficient operation, there is preferably provided a copper jacket 38 on the outside of the vertical sides 32 of yoke 29. Further, inward extending top members 39, also of copper, extend over the tops of the magnets, and there are inwardly downwardly slanted sides 41 inside the innermost ends of the magnets. The angle of sides 41 is approximately equal to that of the sides of the crucibles 22. Bottom 42, also of cooper, is positioned under each array of magnets and the inner ends 43 thereof extend up inside the sides 41.

The modification of Figures 1 and 2 shows the basic outline of an arrangement of horizontal magnets which provides a proper magnetic field for the focusing and guidance of electrons from source 36 to the evaporant in one of the crucibles 22. However, the area beneath the magnets is open for the passage of other crucibles in the turret.

Directing attention now to the modification shown in Figures 3 and 4, the location of horizontal magnets placed about the electron beam path from emitter to evaporant indicates that of major importance is the location or position of the innermost ends of the magnets closest to the crucible. The ends of the magnets closest to the crucible deliver the flux to the beam path. The opposite ends of the magnets are tight against the steel yoke that connects the outer ends of the opposed sets of magnets.

Note in Figure 3, that magnets 26c and 26d are closest to the emitter source and that 28c and 28d are beyond the crucible 22c from the source 36.

In many respects the modification of Figures 3 and 4 resembles that of Figures 1 and 2, and the same references numerals followed by the subscripts c and d indicate parts corresponding to the parts in Figures 1 and without subscripts or with subscript a, respectively.

In the embodiment of Figures 3 and 4 the elevation of magnets 26c and 27c is different than in the embodiment of Figure 2. In essence, the positioning of the magnets may be subject to experimentation in order to achieve the best magnetic field pattern for a particular geometery and the present invention is particularly adapted for ready repositioning of individual magnets. Using small, discrete horizontally disposed magnets having their inner ends close to the electron beam path from the emitter to beyond the crucible improves performance.

Turning now to the modification shown in Figures 5 and 6, the steel yoke 29e, instead of passing under the turret mechanism 23e , is disposed horizontally. This arrangement allows a maximum amount of free space under the focusing magnetic fields which control the electron paths. This arrangement allows more freedom of choice of type and size of crucible with an increased number of crucibles and even a long linear array of multiple crucibles. An inverted crescent-shaped trough may be slowly rotated past the beam, and thus bring a continuous supply of fresh dielectric material, for example, to be evaporated with this magnet this arrangement.

In other respects, the modifications of Figures 5 and 6 resembles that of Figure 1 and 2, and the same reference numerals followed by the subscript e indicates corresponding parts except that the right hand magnets of employ the subscript f.

Figures 7 and 8 illustrate use of electromagnets instead of permanent magnets. The electromagnets may have the same general pole end geometry and location in space as do permanent magnets. The rearward cores 27g and h and 28g and h may be energized by electromagnetic coils 52h on the left and 52g on the right to provide the major mount of flux over crucible 22g. The forward magnets 26g and 26h are energized by coil 53g on the right and 53h on the left. Their main purpose is to adjust the amount of flux for movement of the beam fore and aft although all of them may be used together.

In many respects, the modification of Figure 7 and 8 resembles that of Figure 1 and 2, and the same reference numeral followed by subscripts g and h are used to designate corresponding parts.

Figures 9 and 10 show a linear array of crucibles 22j. By means well understood in the art and hence not illustrated and described herein, the individual crucibles may sequentially be brought into position under the magnets. The crucibles may contain the same evaporant so that as one crucible is depleted another is brought into position. Alternatively, the crucibles may contain different evaporants so that different coatings may be applied to the same or different work pieces, particularly in UHV environments.

Although a magnet array similar to that of Figure 1 and 2 is shown in Figure 9 and 10, it will be understood that the linear array structure may be adapted to other magnet arrays.

In Figure 9 and 10 the subscript j and k have been applied to the basic reference numerals to indicate parts similar to the preceding modifications.

Figure 11 shows a still further modification wherein a unitary array of plural magnets 26l, 27l, 28l (here shown as three, but subject to modification) have a common base 46, and are preferably cast together. Thus, the system employs plural magnets having discrete inner ends extending from a common base 46. The inner ends of magnets 16l, 27l, 28l are free, but their outer ends are joined in a common base 46. Thus, the array may be handled and located in the fabrication of the structure as a unit. The inner ends (nearest the beam) function as discrete units, as in the previous modifications. Each outer end provides its own flux out of the common base 46. On the opposite side of the crucible are magnets 26m, 27m, 28m, also preferably cast together.

In Figure 11 the subscripts l and m are applied to the basic reference numerals to indicate parts similar to the preceding modifications.

In Figures 12 and 13 magnets 26, 27, 28, and 28' are vertically disposed and arranged in a manner similar to said Patent No. 4,835,789. Referring specifically to Figure 13, there are four vertically disposed magnets 26q, 27q, 28q and 28'q having their South poles discrete and their North poles joined in a common base 46q as in the embodiment of Figure 11. It will be understood that magnets 26p, 27p, 28p and 28'p are similarly joined at a common base 46p.

In other respects, the modifications of Figures 12 - 13 resemble the previous modifications and the same reference numerals followed by subscripts p and q indicate corresponding parts.

## Claims

1. An evaporation source apparatus comprising a crucible (22) for containing source material to be evaporated and having a generally horizontal upper surface, an electron beam source (36) displaced from the crucible (22), and means for directing electrons in a path from the electron beam source (36) to the crucible which means includes a first plurality of discrete individual magnets (26,27,28) spaced apart from each other and disposed on one side of the crucible with the same one pole (N) of each magnet adjacent the upper surface of the crucible, a second plurality of discrete individual magnets (26a,27a,28a) spaced apart from each other and disposed on the other side of the crucible opposed to said first plurality of discrete magnets but with the same other pole (S) of each magnet adjacent the upper surface of the crucible, all of the magnets (26,27,28; 26a,26b,26c) being on the same side of the electron beam source as is the crucible (22), and a magnetically permeable structure (29) linking the other poles (S) of the first plurality of magnets with the one poles (N) of the second plurality of magnets, all of the magnets (26,27,28) of the first plurality thereof and all of the magnets (26a,26b,26c) of the second plurality thereof being disposed to extend substantially horizontally above the plane of the generally horizontal upper surface of the crucible (22).

2. Apparatus according to claim 1, wherein the magnetically permeable structure comprises a yoke (29) interconnecting the ends remote from the crucible of all of the magnets (26,27,28; 26a,27a,28a).

3. Apparatus according to claim 2, wherein the yoke (29) has a first portion (31) below the crucible (22) and upwardly extending legs (32) on opposite sides of the crucible (22).

4. Apparatus according to claim 2, wherein the yoke (29e; 29g; 29j; 291) has a first portion disposed horizontally above the level of and remote from the crucible (22) and horizontally disposed legs (32e; 32g; 32j; 321) extending towards the crucible on opposite sides thereof.

5. Apparatus according to any of claims 2 to 4, wherein said yoke (29) is of steel.

6. Apparatus according to any of claims 2 to 5, wherein there is provided a jacket (38) around a substantial portion of the yoke (29).

7. Apparatus according to claim 6, wherein said jacket (38) is of copper.

8. Apparatus according to any of the preceding claims, wherein there are provided copper jackets (39) around the magnets (26,27,28; 26a,27a,28a) of the first and second pluralities thereof.

9. Apparatus according to any of the preceding claims, wherein the number of magnets (26,27,28) of the first plurality thereof is equal to the number of magnets (26a,27a,28a) of the second plurality thereof.

10. Apparatus according to any of the preceding claims, wherein each of the magnets (26,27,28) of the first plurality thereof is directly opposed to a corresponding magnet (26a,26b,26c) of the second plurality thereof.

11. Apparatus according to any of the preceding claims, wherein all of said magnets (26,27,28; 26a,26b,26c) are permanent magnets.

12. Apparatus according to any of claims 1 to 10, wherein all of said magnets (26,27,28; 26a,26b,26c) are electro-magnets.

13. Apparatus according to any of the preceding claims, wherein the one poles (N) of the first plurality of magnets (26,27,28) and the other poles (S) of the second plurality of magnets (26a,26b,26c) are all approximately equidistant from the centre of the crucible (22).

14. Apparatus according to any of the preceding claims, wherein the discrete magnets (26,27,28; 26a,26b,26c) comprise the sole force for directing electrons in said path, from the electron beam source (36).

15. Apparatus according to any of the preceding claims, and which further comprises a second crucible spaced from the first-mentioned crucible and initially being remote from said magnets (26,27,28; 26a,26b,26c) of the first and second pluralities thereof, and crucible transport means (21) for moving the first-mentioned crucible away from said magnets and said second crucible into the position previously assumed by the first-mentioned crucible.

16. Apparatus according to claim 15, wherein said transport means comprises a rotary turret (21), said first-mentioned and second crucibles being located in said turret and angularly spaced from each other, and there being means for indexing the turret.

17. Apparatus according to claim 15, wherein said transport means comprises means (21j) supporting the first-mentioned and second crucibles (22j) in a linear array, and means for linearly moving the array of crucibles.

18. Apparatus according to any of the preceding claims, wherein some of the magnets (26,27,28; 26a,26b,26c) are at a different height above the generally horizontal upper surface of the crucible (22) than others of the magnets.

19. Apparatus according to any of the preceding claims, wherein each magnet has an inner end closer to the crucible (22) and an outer end remote from the crucible, and there is a first base joining the outer ends of the first plurality of magnets (26,27,28) to form a first unitary array of magnets and a second base joining the outer ends of the second plurality of magnets (26a,26b,26c) to form a second unitary array of magnets.

## Patentansprüche

1. Verdampfungsquellenvorrichtung, mit einem Schmelztiegel (22) zur Aufnahme von zu verdampfendem Quellenmaterial und mit einer im wesentlichen horizontal verlaufenden oberen Fläche, einer von dem Schmelztiegel (22) beabstandeten Elektronenstrahlquelle (36) und einer Einrichtung, um die Elektronen von der Elektronenstrahlquelle (36) zu dem Schmelztiegel in einen Pfad zu lenken, wobei die Einrichtung aufweist: eine erste Vielzahl von getrennten einzelnen Magneten (26, 27, 28), die voneinander beabstandet und an einer Seite des Schmelztiegels mit dem gleichen einen Pol (N) von jedem Magneten benachbart zu der oberen Fläche des Schmelztiegels angeordnet sind, eine zweite Vielzahl von getrennten einzelnen Magneten (26a, 27a, 28a), die voneinander beabstandet und an der anderen Seite des Schmelztiegels gegenüber von der ersten Vielzahl von getrennten Magneten, jedoch mit dem gleichen anderen Pol (S) von jedem Magneten benachbart zu der oberen Fläche des Schmelztiegels angeordnet sind, wobei sich alle Magneten (26, 27, 28; 26a, 26b, 26c) auf der gleichen Seite der Elektronenstrahlquelle wie der Schmelztiegel (22) befinden und eine magnetisch permeable Anordnung (29) die anderen Pole (S) der ersten Vielzahl von Magneten mit den einen Polen (N) der zweiten Vielzahl von Magneten verbindet, wobei alle Magneten (26, 27, 28) der ersten Vielzahl und alle Magneten (26a, 26b, 26c) der zweiten Vielzahl so angeordnet sind, um sich im wesentlichen horizontal über der Ebene der im wesentlichen horizontal verlaufenden oberen Fläche des Schmelztiegels (22) zu erstrecken.

2. Vorrichtung nach Anspruch 1, bei der die magnetisch permeable Anordnung ein Poljoch (29) aufweist, durch das die von dem Schmelztiegel entfernten Enden aller Magneten (26, 27, 28; 26a, 27a, 28a) miteinander verbunden sind.

3. Vorrichtung nach Anspruch 2, bei der das Poljoch (29) einen ersten Abschnitt (31) unterhalb des Schmelztiegels (22) und sich an gegenüberliegenden Seiten des Schmelztiegels (22) nach oben erstreckende Schenkel (32) hat.

4. Vorrichtung nach Anspruch 2, bei der das Poljoch (29e; 29g; 29j; 291) einen ersten Abschnitt, der horizontal über der Ebene des Schmelztiegels (22) angeordnet und von diesem beabstandet ist, und horizontal verlaufende Schenkel (32e; 32g; 32j; 321) hat, die sich in Richtung auf den Schmelztiegel an gegenüberliegenden Seiten davon erstrecken.

5. Vorrichtung nach einem der Ansprüche 2 bis 4, bei der das Poljoch (29) aus Stahl besteht.

6. Vorrichtung nach einem der Ansprüche 2 bis 5, bei der eine Umkleidung (38) um einen wesentlichen Bereich des Poljochs (29) vorgesehen ist.

7. Vorrichtung nach Anspruch 6, bei der die Umkleidung (38) aus Kupfer besteht.

8. Vorrichtung nach einem der vorhergehenden Ansprüche, bei der Kupfer-Umkleidungen (39) um die erste und die zweite Vielzahl der Magneten (26, 27, 28; 26a, 27a, 28a) vorgesehen sind.

9. Vorrichtung nach einem der vorhergehenden Ansprüche, bei der die Anzahl der Magneten (26, 27, 28) der ersten Vielzahl gleich der Anzahl der Magneten (26a, 27a, 28a) der zweiten Vielzahl ist.

10. Vorrichtung nach einem der vorhergehenden Ansprüche, bei der jeder der Magneten (26, 27, 28) der ersten Vielzahl davon direkt gegenüberliegend zu einem entsprechenden Magneten (26a, 26b, 26c) der zweiten Vielzahl davon angeordnet ist.

11. Vorrichtung nach einem der vorhergehenden Ansprüche, bei der alle Magneten (26, 27, 28; 26a, 26b, 26c) Permanentmagneten sind.

12. Vorrichtung nach einem der Ansprüche 1 bis 10, bei der alle Magneten (26, 27, 28; 26a, 26b, 26c) Elektomagneten sind.

13. Vorrichtung nach einem der vorhergehenden Ansprüche, bei der die einen Pole (N) der ersten Vielzahl von Magneten (26, 27, 28) und die anderen Pole (S) der zweiten Vielzahl von Magneten (26a, 26b, 26c) etwa mit der gleichen Distanz von dem Mittelpunkt des Schmelztiegels (22) beabstandet sind.

14. Vorrichtung nach einem der vorhergehenden Ansprüche, bei der die getrennten Magneten (26, 27, 28; 26a, 26b, 26c) die einzige Kraft bilden, um die Elektronen von der Elektronenstrahlquelle (36) in den Pfad zu lenken.

15. Vorrichtung nach einem vorhergehenden Ansprüche, die außerdem aufweist: einen zweiten Schmelztiegel, der von dem erstgenannten Schmelztiegel beabstandet und anfänglich von den Magneten (26, 27, 28; 26a, 26b, 26c) der ersten und zweiten Vielzahl davon beabstandet ist, und eine Schmelztiegel-Transporteinrichtung (21), um den erstgenannten Schmelztiegel von den Magneten wegzubewegen und um dem zweiten Schmelztiegel in die Position zu bewegen, die zuvor von dem erstgenannten Schmelztiegel eingenommen wurde.

16. Vorrichtung nach Anspruch 15, bei der die Transporteinrichtung einen sich drehenden Revolverkopf (21) aufweist, bei der der erstgenannte und der zweite Schmelztiegel in dem Revolverkopf angeordnet und mit einem Winkel voneinander beabstandet sind, und bei der Einrichtungen zum Weiterdrehen des Revolverkopfes vorgesehen sind.

17. Vorrichtung nach Anspruch 15, bei der die Transporteinrichtung (21j) Einrichtungen, die den erstgenannten und den zweiten Schmelztiegel (22j) in einer geradlinigen Gruppierung halten, und Einrichtungen hat, um die Gruppierung der Schmelztiegel geradlinig zu bewegen.

18. Vorrichtung nach einem der vorhergehenden Ansprüche, bei der einige der Magneten (26, 27, 28; 26a, 26b, 26c) in einer anderen Höhe oberhalb der im wesentlichen horizontal verlaufenden oberen Fläche des Schmelztiegels (22) angeordnet sind als andere der Magneten.

19. Vorrichtung nach einem der vorhergehenden Ansprüche, bei der jeder Magnet ein innenliegendes Ende, das näher zum Schmelztiegel (22) liegt, und ein außenliegendes Ende hat, das von dem Schmelztiegel entfernt ist, und bei der eine erste Basis, durch die die außenliegenden Enden der ersten Vielzahl von Magneten (26, 27, 28) verbunden sind, um eine erste einheitliche Gruppe von Magneten zu bilden, und eine zweite Basis vorgesehen ist, durch die die außenliegenden Enden der zweiten Vielzahl von Magneten (26a, 26b, 26c) verbunden sind, um eine zweite einheitliche Gruppe von Magneten zu bilden.

## Revendications

1. Appareil à source d'évaporation, comprenant un creuset (22) pour contenir une matière source à évaporer et ayant une surface supérieure généralement horizontale, une source de faisceau d'électrons (36) décalée par rapport au creuset (22), et des moyens pour guider des électrons dans un trajet allant de la source de faisceau d'électrons (36) au creuset, lesquels moyens comprennent une- première pluralité d'aimants individuels discrets (26, 27, 28) écartés les uns des autres et disposés d'un côté du creuset, le même premier pôle (N) de chaque aimant étant adjacent à la surface supérieure du creuset, une seconde pluralité d'aimants individuels discrets (26a, 27a, 28a) écartés les uns des autres et disposés de l'autre côté du creuset, opposé à la première pluralité d'aimants discrets, mais le même autre pôle (S) de chaque aimant étant adjacent à la surface supérieure du creuset, tous les aimants (26, 27, 28; 26a, 26b, 26c) étant du même côté de la source de faisceau électrons que le creuset (22), et une structure magnétiquement perméable (29) reliant les autres pôles (S) de la première pluralité d'aimants avec les premiers pôles (N) de la seconde pluralité d'aimants, tous les aimants (26, 27, 28) de la première pluralité et tous les aimants (26a, 26b, 26c) de la seconde pluralité étant disposés pour s'étendre sensiblement horizontalement au-dessus du plan de la surface supérieure généralement horizontale du creuset (22).

2. Appareil selon la revendication 1, dans lequel la structure magnétiquement perméable comprend une culasse (29) reliant entre elles les extrémités éloignées du creuset de tous les aimants (26, 27, 28; 26a, 27a, 28a).

3. Appareil selon la revendication 2, dans lequel la culasse (29) a une première partie (31) en-dessous du creuset (22) et des bras s'étendant vers le haut (32) sur des côtés opposés du creuset (22).

4. Appareil selon la revendication 2, dans lequel la culasse (29e; 29g; 29j; 29l) a une première partie disposée horizontalement au-dessus du niveau du creuset (22) et à distance de celui-ci, et des bras disposés horizontalement (32e; 32g; 32j; 32l) s'étendant vers le creuset sur des côtés opposés de celui-ci.

5. Appareil selon l'une quelconque des revendications 2 à 4, dans lequel ladite culasse (29) est en acier.

6. Appareil selon l'une quelconque des revendications 2 à 5, dans lequel il est prévu un chemisage (38) autour d'une partie substantielle de la culasse (29).

7. Appareil selon la revendication 6, dans lequel ledit chemisage (38) est en cuivre.

8. Appareil selon l'une quelconque des revendications précédentes, dans lequel il est prévu des chemisages en cuivre (39) autour des aimants (26, 27, 28; 26a, 27a, 28a) des première et seconde pluralités.

9. Appareil selon l'une quelconque des revendications précédentes, dans lequel le nombre d'aimants (26, 27, 28) de la première pluralité est égal au nombre d'aimants (26a, 27a, 28a) de la seconde pluralité.

10. Appareil selon l'une quelconque des revendications précédentes, dans lequel chacun des aimants (26, 27, 28) àe la première pluralité est directement opposé à un aimant correspondant (26a, 26b, 26c) de la seconde pluralité.

11. Appareil selon l'une quelconque des revendications précédentes, dans lequel tous lesdits aimants (26, 27, 28; 26a, 26b, 26c) sont des aimants permanents.

12. Appareil selon l'une quelconque des revendications 1 à 10, dans lequel tous lesdits aimants (26, 27, 28; 26a, 26b, 26c) sont des électroaimants.

13. Appareil selon l'une quelconque des revendications précédentes, dans lequel les premiers pôles de la première pluralité d'aimants (26, 27, 28) et les autres pôles (S) de la seconde pluralité d'aimants (26a, 26b, 26c) sont tous approximativement équidistants du centre du creuset (22).

14. Appareil selon l'une quelconque des revendications précédentes, dans lequel les aimants discrets (26, 27, 28; 26a, 26b, 26c) constituent la seule force pour guider les électrons dans ledit trajet, à partir de la source de faisceau d'électrons (36).

15. Appareil selon l'une quelconque des revendications précédentes, et qui comprend en outre un second creuset espacé du creuset mentionné en premier lieu, et initialement éloigné desdits aimants (26, 27, 28; 26a, 26b, 26c) de la première et de la seconde pluralité, et des moyens de transport de creuset (21) pour éloigner desdits aimants le creuset mentionné en premier lieu et amener le second creuset dans la position précédemment occupée par le creuset mentionné en premier lieu.

16. Appareil selon la revendication 15, dans lequel les moyens de transport comprennent une tourelle rotative (21), ledit creuset mentionné en premier lieu et ledit second creuset étant situés dans ladite tourelle et angulairement espacés l'un de l'autre, des moyens étant prévus pour indexer la tourelle.

17. Appareil selon la revendication 15, dans lequel les moyens de transport comprennent des moyens (21j) supportant le creuset mentionné en premier lieu et le second creuset (22j) selon un arrangement linéaire, et des moyens pour déplacer linéairement l'arrangement de creusets.

18. Appareil selon l'une quelconque des revendications précédentes, dans lequel certains des aimants (26, 27, 28; 26a, 26b, 26c) sont à une hauteur différente au-dessus de la surface supérieure généralement horizontale du creuset (22) par rapport à d'autres des aimants.

19. Appareil selon l'une quelconque des revendications précédentes, dans lequel chaque aimant a une extrémité intérieure plus proche du creuset (22) et une extrémité extérieure éloignée du creuset, et il est prévu une première base joignant les extrémités extérieures de la première pluralité d'aimants (26, 27, 28) pour former un premier arrangement unitaire d'aimants, et une seconde base joignant les extrémités de la seconde pluralité d'aimants (26a, 26b , 26c) pour former un second arrangement unitaire d'aimants.
